# EUROPEAN PATENT APPLICATION

(11) **EP 3 591 837 A1**
(43) Date of publication of application: **08.01.2020**
(21) Application number: 18181588.7
(22) Date of filing: 04.07.2018
(51) Int. Cl.: H02S 30/10, H01L 31/042

(54) **SOLAR MODULE WITH REDUCED PID EFFECT**

(71) Applicant: Covestro Deutschland AG, 51373 Leverkusen (DE)
(72) Inventor: Hocke, Heiko, Shanghai 200120 (CN); Chen, Ruqi, Shanghai 200237 (CN); Zhao, Dong Bo, Shanghai 201206 (CN); Deng, Zoe, Shanghai 201206 (CN); Tang, Demi, Shanghai 201206 (CN)
(74) Representative: Levpat

(57) **Abstract**

The present invention concerns a solar module A comprising at least a stack B made of pane(s) of glass, a polymeric encapsulation material, crystalline silicon cell(s) and optionally a back sheet, a frame C made of polymeric composite materials based on aliphatic polyisocyanates and optionally a sealant D. It is characterized by an excellent long term weathering resistance, high durability, low maintenance efforts and low perceptibility to PID.

## Description

The present invention concerns a new type of solar module comprising at least a stack made of pane(s) of glass, two layers of encapsulation polymer, silicon cells and wiring, and optionally a back sheet. The stack is framed by a non-coated profile of polymeric composite materials based on aliphatic polyisocyanates and optionally a sealant. The new type of solar module is characterized by an excellent long term weathering resistance, high durability, low maintenance efforts and a high resistance to potential induced degradation processes.

Solar energy obtained from solar modules is recognized as one important option to produce energy in a sustainable way. Consequently, the industry enjoyed a high growth rate over the last decade and the yearly installation of new solar modules is expected to exceed 80 GW in 2018 (source: *GTM Research* Global Solar Monitor Q1/2017). At the same time, the industry has matured and is now permanently looking for cost efficient and highly reliable solutions.

Currently, different types of solar modules exist on the market. Most common are solar modules based on monocrystalline or polycrystalline silicon cells. Generally, such modules are built up as a stack of several layers. The upper side of the module facing the sun light is formed by a pane of glass, which needs to be highly transparent in order to capture the light. In addition, the pane works as a barrier to oxygen and moisture as well as a mechanical support. Then usually follows an encapsulating material, e.g. a polymer sheet made of ethylene-vinyl acetate copolymer, polysilicone or polyethylene derivatives, which is also transparent and protects the electrically interconnected silicon cells. Finally, another layer of encapsulation material and another barrier which may be a polymeric back sheet or another pane of glass completes the stack. All layers are well bonded to one another by a lamination process and form a unit (stack). The edge of the stack is surrounded by a frame that provides mechanical support to the module (especially stiffness), protects the edges of the pane of glass from damage by hits during installation and transport, and functions as support element in the installation of the module. The connection between the stack and the frame is achieved by using an elastic polymer sealant, often a silicone. This frame sealant also acts as barrier on the edges of the stack and ideally prevents the ingress of moisture or oxygen. Furthermore, the frame sealant must provide sufficient flexibility to compensate for the different thermal expansion of the stack material, especially the pane of glass, and the frame material during temperature cycles.

Looking at the interface of the stack and the frame the following requirements need to be ideally fulfilled:
a. The frame should have at least the same or better lifetime (durability) as the stack. The durability should be achieved without further maintenance over the life cycle of the module in all environments (sea side, urban areas, desert, tropics, buildings close to life stock areas etc).
b. The coefficient of linear thermal expansion (CLTE) of the frame and the stack along the edges should be same or similar to reduce the stress on the frame sealant during temperature cycles, e.g. day and night in a desert or usage in different climate zones. This also improves the barrier function of the frame sealant and consequently improves the lifetime of the solar module.
c. The frame should provide sufficient stiffness to enhance the mechanical overall performance of the module, e. g. in case of snow or wind load, and protect the stack edges against damages during transportation and installation of the module.
d. The frame should provide sufficient support to install the module, e.g. by clamping on a base frame.
e. The frame should be electrically non-conductive. That significantly decreases the susceptibility for potential induced degradation (PID), an effect caused by harmful leakage currents over an extended period of time, and that may reduce the performance of crystalline silicon photovoltaic modules up to 30%.
f. The frame should be easy to recycle and should have a low carbon foot print.
g. The frame should fit esthetically, e.g. color, to the stack and the environment especially for building integrated photovoltaic modules.

Nowadays, aluminum is widely used as frame material especially for solar modules. It combines very good mechanical properties with good weathering fastness for most environments (requirement c, partly a). The frame protects the glass pane effectively and serves also as support to clamp the module onto a rack or any other assembly device (d). To achieve the outstanding chemical resistance the aluminum is usually surface treated, e.g. by anode oxidation. Nevertheless, in salt water environment or mist aluminum will gradually react with water (misses partly item a). Furthermore, an expensive coating must be applied if colors other than the "typical" aluminum silver are desired (missing item g). Another serious disadvantage is the high electrical conductivity of aluminum for solar modules (missing item e). The electrical conductive aluminum frame brings the high electric potential to ground in close proximity of the silicon wafer and in direct contact with the glass pane. As a result, potential induced degradation was observed in such solar modules (source: *Photon* 12/2010). Furthermore, the coefficient of linear thermal expansion of aluminum is significant higher than that of glass (misses item b). This difference leads to challenges especially for the edge sealing in larger solar modules over expanded time periods. Despite its good recyclability in principle, the costs for aluminum are rather high, and the carbon footprint is high due to its energy consumption during the production (misses partly item f).

Lately, polymeric composites have been proposed by A. Raymond ET CIE (WO 2013/010091), Bayer MaterialScience (US 2011/030767) and others as frames for solar modules. These composites have been often thermoplastic or thermoset based polymers as matrix materials and glass fibers as reinforcing fillers. Typical examples of matrix materials are polybutyleneterephthalate (PBT) and blends thereof as well as polyurethanes based on aromatic polyisocyanates (WO 2009/121502A2). Although these composites and especially the one's based on aromatic polyurethane such as Baydur PUL 2500 (WO 2014/019959) provide many advantages such as good mechanical performance, low coefficient of linear thermal expansion and basically no electrical conductivity , however, as such they are not suitable for long term outdoor use. UV light and moisture in combination with heat easily decomposes the aromatic and polyether moieties in the matrix of the composite in rather short time. Additives known in the industry may extend the life time somewhat but not for 20 years and more. In order to prevent degradation they need protective coatings. If the composites are manufactured by the pultrusion process, the application of coatings is difficult due to the release agent on the surface of such parts. Thus, further treatment may be required to achieve a good bonding between e.g. the polyurethane body and the coating. These additional processing steps make such solutions expensive and the overall long term durability of such coated composites has not yet been proven. Another disadvantage of coatings is that they are prone to abrasion processes in which case the protective effect of the coating layer is obliterated. Abrasion processes, however, are unavoidable over such long life time and can be even very significant in preferred areas for solar power generation (deserts - sand storms or simply dust particles in combination with wind).

In general, several methods have been developed over the years to address the problem of potential induced performance degradation (PID) of solar modules but there are no truly and simple solutions to provide solar module with high intrinsic resistance to PID or which do not suffer from PID environment during their whole lifetime.

As discussed above, the edges of a solar module are very critical areas for the life time and performance of the module. Current approaches address the problems to a different degree but no approach provides an overall satisfying solution. Either the mechanical protection of the edges and weathering fastness are good but the PID effect and difference in CLTE between stack and frame are issues (aluminum frame), or the mechanical and PID protection is good but the weathering fastness and durability is a problem (current coated polymeric frames). Hence, the problem underlying the present invention was the provision of a solution that provides all desired features (mechanical protection of the module edges, suppressing the PID effect, excellent weathering fastness and durability, edge sealing, freedom of color, support for mounting the module, e.g. by commonly use clamping) at the same time and at reasonable costs.

Therefore, in a first embodiment the present invention relates to a solar module A comprising
a) at least one stack B comprising pane(s) of glass, a polymeric encapsulation material, silicon cell(s), electrical wiring and optionally a back sheet; and
b) a frame C made of a non-coated thermoset polymeric composite material comprising a polymer matrix which is based on at least 50 wt.-% of an aliphatic polyisocyanate; and
c) optionally at least one sealant D that connects the stack B with frame C.

### Solar module A

The solar module A according to the invention comprises at least one stack B, one frame made of polymeric composite material and optionally one sealant D that connects the stack B with the frame C. The frame C stabilizes the stack B mechanically and optionally offers further elements to mount the solar module A onto a base frame. It may surround the stack B completely or partly. However, it is preferred that cumulated at least 25 %, more preferred at least 50 % and even more preferred at least 75 % of the circumference of stack B are embedded into the frame C.

In one preferred embodiment, the solar module A comprises a stack B that is completely surrounded on the edge by a frame C made of polymeric weather resistant polymeric composite, and optionally a sealant which connects the stack B with the frame C.

The size and shape as well as the weight of the solar module A are important for good and economic handling and installation. If the module A is too big or heavy, handling during installation will be difficult and the stiffness of the materials might be not sufficient to guarantee the mechanical stability. If the size of the module A is too small the cost for handling as calculated nominal solar power/ handling cost and material costs for frame are too expensive. Therefore, a balance of size with regard to handling and material costs as well as nominal power output per module is needed.

In one embodiment of the invention, the solar module A has a rectangular shape. The side length of this rectangular shape is between 45 cm and 300 cm, more preferred between 60 cm and 250 cm and most preferred between 95 cm and 185 cm.

In a preferred embodiment of the invention the longest side of the rectangular shaped module A is between 95 cm and 300 cm, more preferred between 130 cm and 200 cm and most preferred between 155 cm and 185 cm.

In one embodiment of the invention the solar module A has a surface area at the front side (facing the sun) between 0.50 m² and 2.0 m², more preferred between 1.0 m² and 2.0 m² and most preferred between 1.25 m² and 1.90 m².

In another embodiment the weight of solar module A is between 5 kg and 30 kg, more preferred between 10 kg and 28 kg and most preferred between 15 kg and 20 kg.

The solar module A is at least partially exposed to outdoor conditions. Preferably at least a part of the frame C is exposed to rain and/or solar radiation without any type of screen which protects the exposed part of the frame C or module A from said exposure.

To ensure highest efficiency, in a preferred embodiment of the invention the solar module A is completely exposed to outdoor conditions and exposed to weather conditions of the surrounding area.

In a preferred embodiment of the invention the solar panel A if exposed to accelerated weathering tests (thermal cycling test 10.11, humidity freeze test 10.12, damp heat test 10.13) as required by certification of solar modules (standard IEC 61215:2005) will pass the tests at least once, preferably at least twice and more preferably at least 3 times without any significant visible changes or decrease of its performance. Significant decrease of performance of module A is given if the DC output power (nominal power) under standard test conditions (STC: irradiance of 1,000 W/m², solar spectrum of AM 1.5 and module temperature at 25 °C) decreases by 20 %. Moreover, a solar module A will pass the certification required by standard IEC 61215:2005.

The solar module A is exposed to outdoor conditions in sum at least 10 years, preferably at least 15 years, more preferably at least 20 years and most preferably at least 25 years.

A solar module is often not used as standalone unit but connected with more modules to form a photovoltaic array of a photovoltaic system. The produced DC power is for better transportation and usage converted to AC power by an inverter. In order to keep costs down, e.g. for wiring, and to have a high efficiency during the conversion process it is desired to have a high voltage and low current. Therefore, modules are wired in series to have up to several hundreds of volts DC power in an array. However, the higher the voltage the more likely is the appearance of PID effects, especially if the module has an aluminum frame which is also used to mount the module on a rack (source: *Photon* 12/ 2010; presentation of SOLON SE at PVSEC inValencia 2010).

In an embodiment of the invention solar module A is used as part of a photovoltaic array where modules are connected in a serial fashion and the array has a DC voltage of at least 600 Volt, more preferred at least 900 Volt, even more preferred of 1400 Volt and most preferred of 1550 Volt or higher. It is understood that due to technical restrictions the voltage in the photovoltaic array should not exceed 5000 Volt in order to avoid short cuts in the wiring.

### Stack B

Stack B used in the solar module A may have different combinations of materials but the general assembly and function of layers are same or comparable. Preferably, stack B comprises 5 layers:
(i) A pane of glass A1;
(ii) A transparent encapsulating polymer A2;
(iii) Silicon cells and wiring A3;
(iv) A transparent encapsulating polymer A4; and
(v) A back sheet A5.

The pane of glass A1 is preferably made of solar glass, a special grade for solar industry that is low on iron content and provides a high transmittance of light within the range favorable for the working of the silicon cells. It may be treated on the outside with a special anti-reflective coating (ARC) to harvest more light. Further functions of the pane of glass are to provide mechanical stability to the module and barrier properties against moisture or oxygen ingress. The second layer is a transparent encapsulating polymer A2. Said polymer A2 is preferably based on an ethylene-vinyl acetate-copolymer. Also suitable are encapsulating materials made from polymers derived from silicone or ethylene. The function of the encapsulating layer is to protect the silicon cells and wiring from mechanical impact and chemicals (corrosion). All definitions given above for the encapsulating polymer A2 also apply to the encapsulating polymer A4. In a preferred embodiment of the present invention encapsulating polymers A2 and A4 have the same composition. In addition, encapsulating polymers A2 and A4 fix the positions of the silicon cells (third layer) and work as adhesive to connect all layers in stack B. Silicon cells together with the wiring form the third layer A3 and are embedded in the encapsulation layers A2 and A4. The silicon cells are made of crystalline silicon which may be monocrystalline or polycrystalline silicon, connected by wires to form a circuit and are the actual photovoltaic active component of the solar panel. The cells convert the light into direct current. The fifth layer is a back sheet A5. It is either a polymeric back sheet or another pane of glass. The polymeric back sheet can comprise one or more individual layers of different polymers such as polyamide (PA), polyethylene terephthalate (PET), polyolefin and fluorinated polymers (PTFE, PVDF). The function of the back sheet is to provide mechanical protection and barrier properties especially against moisture and oxygen. It may or may not be transparent. Both moisture and oxygen are harmful to the inner layers such as the encapsulating material or the metal wires and may cause degradation of the polymers or corrosion of the electrical contacts that finally impact the performance and life time of the module.

The stack B used in the solar module A has a thickness between 2 mm and 20 mm, preferably between 3.0 mm and 10 mm, more preferably between 3.5 mm and 8 mm and most preferably between 4.0 mm and 7.0 mm.

In another embodiment of the invention the surface area of the stack B is at least 0.5 m², preferably at least 1.0 m², more preferably at least 1.25 m² and most preferably at least 1.5 m². Preferably, the surface area is not larger than 2.0 m². The surface area is defined as the front side area of the stack B (directed to the sun), and that is not covered by the frame C.

According to the invention the advantages (similar CLTE of the stack B and frame C) of the new solar module A are especially emphasized if the stack B of the module A is large. Large in the meaning of the invention means that the circumference of stack B is at least 2.0 m, preferably more than 3.0 m, more preferably more than 4.0 m, and most preferably more than 5.0 m, while having the surface area defined in the paragraph above. Preferably, the circumference is not larger than 7.0 m for practical reasons.

The pane of solar glass as main part of stack B is determining the coefficient of linear thermal expansion (CLTE) of the stack. Therefore, the CLTE measured according TM 900026 (-20 °C, 100 °C) of the stack B is between 1.0*10⁻⁶ K⁻¹ and 15*10⁻⁶ K⁻¹, preferably between 2.0*10⁻⁶ K⁻¹ and 11.0*10⁻⁶ K⁻¹, more preferably between 3.0*10⁻⁶ K⁻¹ and 10.0*10⁻⁶ K⁻¹ and most preferably between 4.0*10⁻⁶ K⁻¹ and 9.0* 10⁻⁶ K⁻¹.

### Frame C

The frame C is shaped to surround at least a part of the circumference of stack B. This means that the frame C covers at least a part of the edge of stack B and optionally a part of the surface adjacent to said edge so that pane B is moved into its intended position and kept in this position by orientating frame C.

A preferred shape for this purpose is a profile with a notch or an indention into which the edge of stack B can be inserted so that stack B is friction-locked with frame C or form-locked. Thus, the actual shape of the frame C is determined by the shape of the edges of stack B. If the optional sealant D is present, the required notch in the profile is large enough to insert stack B as well as the required amount of sealant while meeting the requirements of friction-lock or form-lock.

Without any intention to limit the scope for possible designs of frame C an example for a shape of such profile used as frame C is shown in figure 2 of publication WO 2014/019959A1 as reference.

Preferably, at least 25 % of the circumference of stack B are surrounded by frame C. More preferably at least 50 % and even more preferably at least 75 % of the circumference of stack B are surrounded by frame C. Most preferably stack B is completely surrounded by frame C.

Frame C consists of a non-coated composite material comprising inorganic fibers embedded in a polymer matrix. Said composite material is, preferably, electrically insulating.

Electrical insulation can improve the durability of devices and may also contribute to a safe handling, particularly where high currency is involved. For example, solar modules suffer sometimes from an effect called PID (potential induced degradation). The suggested cause is the high voltage of up to 1000 V of serially connected modules that is due to the aluminum frame in direct contact with the glass-polymer-stack which leads to a migration of ions, e.g. sodium ion, from the pane of glass into the silicon cell. An electrically non-conductive frame prevents such degradation and as a result improves the life time and efficiency of the solar module. The electrical resistivity of frame C is therefore preferably at least 10⁹ Ohm, more preferably at least 10¹² Ohm and even more preferably at least 10¹⁴ Ohm measured according to standard ASTM D257.

The term "coated" or "coating" means that there is an additional layer or covering of material applied on top of the surface of the substrate (core material, composite). This layer has a distinct thickness and a boundary that separates this layer from the substrate. In general, the chemical composition of this layer is different from the resin of the composite. The layer is applied to the composite surface after forming the composite part, and often even in a separate process step. The coating usually fulfills functional requirements such as protection, surface modification of mechanical or chemical nature, or simply decorative appearance. The term "non-coated" means that such layer does not exist on at least 20 %, preferably at least 50 % and more preferably at least 75 % of the surface of the composite part. Most preferred is that no such layer, i.e. no coating, is applied to frame C.

The inorganic fibers may be glass fibers or basalt fibers, however, glass fibers are preferred in order to match the CLTE of stack B best. Preferably, the composite material of frame C has a fiber content between 40 wt.-% and 95 wt.-%, more preferably between 50 wt.-% and 90 wt.-% and even more preferably between 60 wt.-% and 90 wt.-%. Most preferred is a glass fiber content of frame C between 70 wt.-% and 85 wt.-%. The content of glass fiber is given with respect to the overall weight of the composite material.

In order to facilitate better the embedding of the stack B into the frame C the coefficient of linear thermal expansion (CLTE) as measured according to TM 900026 in axial direction should be preferably same or at least similar for stack B and frame C. Therefore variances of temperature which are typically encountered in outdoor conditions due to seasonal changes and the night-day-rhythm cause less stress on the connection of the stack B with the frame C or sealant D. In addition, more freedom of design and higher accuracy of the parts and consequently better appearance of solar module A are advantageous side effects.

The CLTE of the frame C in axial direction, i.e. parallel to the fiber orientation, is between 1.0*10⁻⁶ K⁻¹ and 17*10⁻⁶ K⁻¹, preferably between 2.0*10⁻⁶ K⁻¹ and 11.0*10⁻⁶ K⁻¹, more preferably between 3.0*10⁻⁶ K⁻¹ and 10.0*10⁻⁶ K⁻¹ and most preferably between 4.0*10⁻⁶ K⁻¹ and 9.0*10⁻⁶ K⁻¹ (measured according to TM 900026; -20 °C, 100 °C).

In another embodiment of the invention the difference of CLTE of stack B and of frame C measured in axial direction according to TM 900026, i.e. parallel to the fiber orientation and along the edge of stack B, is not more than 1000 %, preferably not more than 400 %, more preferably not more than 200 %, even more preferably not more than 100 % and most preferably not more than 50 %. The difference is calculated as follows: absolute value (CLTE of pane of glass of stack B minus CLTE of frame C) divided by CLTE of pane of glass of stack B multiplied by 100 %.

### Polymeric composite material

The meaning of the term "polymeric composite material" is well known to the person skilled in the art. It refers to a material made of inorganic fibers, particularly glass or basalt fibers, which are embedded into a polymer matrix. Preferably, the polymeric composite material is produced by the pultrusion process which is well known in the art.

### Polymer matrix

The matrix material of frame C might be any thermoset or thermoplastic polymeric material that has excellent weathering fastness. Examples for such polymers are thermoplastic fluorinated polymers such as polytetrafluoroethylene (PTFE) or polyvinylidene difluoride (PVDF) and thermoplastic or thermoset polyurethanes or polyisocyanurates. Preferred is a thermoset material due to its better creep performance over the intended application time of the frame. Even more preferred is a thermoset material based on aliphatic polyisocyanates. Such thermoset materials are produced from aliphatic polyisocyanates resins containing at least 50 wt.-%, more preferably at least 70 wt.-% and even more preferably at least 80 wt.-% of aliphatic and cycloaliphatic polyisocyanates. Aliphatic and cycloaliphatic polyisocyanates useful for manufacturing the polymer matrix are monomeric polyisocyanates as well as oligomeric polyisocyanates. Furthermore, the reaction mixture used for manufacturing the polymer matrix does not contain more than 40 wt.-%, preferably not more than 20 wt.-%, more preferably not more than 10 wt.-%, even more preferably not more than 5 wt.-% and most preferably not more than 1 wt.-% aromatic and araliphatic polyisocyanates.

Aliphatic polyisocyanates which are suitable for the manufacture of the polymer matrix are 1,4-diisocyanatobutane (BDI), 1,5-diisocyanatopentane (PDI), 1,6-diisocyanatohexane (HDI), 2-methyl-1,5-diisocyanatopentane, 1,5-diisocyanato-2,2-dimethylpentane, 2,2,4- or 2,4,4-trimethyl-1,6-diisocyanatohexane, 1,10-diiisocyanatodecane, 1,3- and 1,4-diisocyanatocyclohexane, 1,4-diisocyanato-3,3,5-trimethylcyclohexane, 1,3-diisocyanato-2-methylcyclohexane, 1,3-diisocyanato-4-methylcyclohexane, 1-isocyanato-3,3,5-trimethyl-5-isocyanatomethylcyclohexane isophorone diisocyanate (IPDI), 1-isocyanato-1-methyl-4(3)-isocyanatomethylcyclohexane, 2,4'- and 4,4'-diisocyanatodicyclohexylmethane (H12MDI), 1,3- and 1,4-bis(isocyanatomethyl)cyclohexane, bis(isocyanatomethyl)norbornane, 4,4'-diisocyanato-3,3'-dimethyldicyclohexyl methane, 4,4'-diisocyanato-3,3',5,5'-tetramethyldicyclohexylmethane, 4,4'-diisocyanato-1,1'-bi(cyclohexyl), 4,4'-diisocyanato-3,3'-dimethyl-1,1'-bi(cyclohexyl) or a mixture of at least two thereof. Preferred is the use of HDI, PDI and IPDI. Particularly preferred is the use of HDI.

Said aliphatic may be used as such, i.e. as monomeric polyisocyanates, for manufacturing the polymeric composite material. However, they may be also used as oligomeric polyisocyanates obtained from the reaction of two monomeric polyisocyanates. This oligomerization leads to oligomeric polyisocyanates linked by at least one structure selected from the group consisting of uretdione, isocyanurate, allophanate, biuret, iminooxadiazinedione and/or oxadiazinetrione structures or a mixture of at least two thereof.

In order to achieve the desirable resistance of the material and its excellent mechanical properties, it is essential that the amount of ester and ether moieties in the polymer matrix is limited. Therefore, the ratio of aliphatic polyisocyanates and isocyanate reactive compounds other than the short chain polyols defined below in the reaction mixture is at least 5 : 1 (weight/weight), preferably at least 10 : 1 (weight/weight) and most preferably at least 20 : 1 (weight/weight). An "isocyanate reactive compound" as understood in the present application is any compound which carries at least one hydroxyl, thiol or amino group.

Short chain polyols which are suitable for manufacturing a polymer matrix according to the present invention have an average functionality of at least two and an OH content between 25 % by weight and 60 % by weight, preferably between 30 % by weight and 60 % by weight and more preferably between 35 % by weight and 60 % by weight.

Preferred short chain polyols are glycerol, 1,1,1-trimethylolpropane, 1,1,1-trimethylolethane, pentaerythritol, 1,2,10-decanetriol, 1,2,8-octanetriol and sugar alcohols or a mixture of at least two thereof. Particularly preferred is glycerol.

The polymer matrix is preferably manufactured from a reaction mixture comprising aliphatic isocyanates as defined above and short chain polyols as defined above, wherein the molar ratio between isocyanate groups and hydroxyl groups of the short chain polyols in the reaction mixture is at least 0.8 : 1.0, preferably 0.9 : 1.0, more preferably 1.1 : 1.0, even more preferably 1.3 : 1.0 and most preferably 1.5 : 1,0. There is no upper limit to this range because the formation of the polymer matrix is not dependent on the formation of urethane groups but can also be mediated by the formation of are isocyanurate groups, uretdione groups, biuret groups, iminooxadiazinedione and oxadiazintrione groups.

In a preferred embodiment of the present invention the molar ratio of isocyanate groups to all groups reactive with isocyanate groups in the reaction mixture used for manufacturing the polymer matrix is at least 2 : 1, preferably at least 5 : 1 and more preferably at least 10 : 1. Thus, the amount of any isocyanate reactive compound - including short chain polyols - is limited in this embodiment of the present invention.

Therefore, in this embodiment the polymer matrix is predominantly crosslinked by functional groups which are formed by the reaction of one isocyanate group with another isocyanate group. Such functional groups are isocyanurate groups, uretdione groups, biuret groups, iminooxadiazinedione and oxadiazintrione groups.

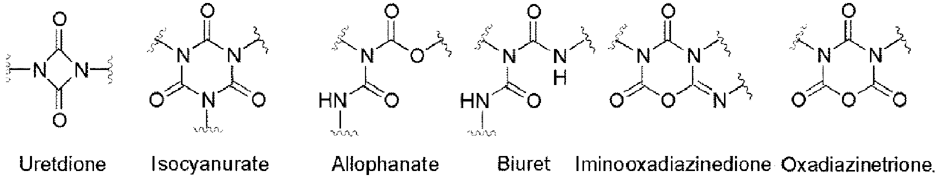

The person skilled in the art knows many catalysts and the appropriate reaction conditions for crosslinking isocyanate groups.

Useful catalysts for manufacturing the composite material from a reaction mixture with a low content of isocyanate reactive groups are typical trimerisation catalysts. Especially suited are catalysts that comprises potassium acetate or potassium octoate and polyethylene glycol. Particularly useful are potassium acetate and a polyethylene glycol with a number-average molecular weight Mn between 350 and 400 g/mol. The polyethylene glycol preferably has a polydispersity of less than 5.

This catalyst has sufficient solubility or dispersibility in the reaction mixture in the amounts that are required for initiation of the crosslinking reaction. The trimerization catalyst is therefore preferably added to the polyisocyanate resin composition in neat form.

"Addition of the trimerization catalyst in neat form" means that the metal salt is dissolved or at least suspended in the polyether. The proportion of the metal salt in this solution is less than 50 % by weight, preferably less than 25 % by weight, more preferably less than 20 % by weight or less than 15 % by weight, and especially less than 10 % by weight. However, the proportion is in any case greater than 0.01 % by weight. The aforementioned proportions are based on the total weight of metal salt and polyether.

The crosslinking is preferably effected at temperatures between 80 °C and 350 °C, more preferably between 100 °C and 300 °C and most preferably between 150 °C and 250 °C.

If significant amounts of short chain polyols are present in the reaction mixture, any catalyst which mediates the formation of urethane groups can be used. Suitable catalysts can be found, for example, in Becker / Braun, Kunststoffhandbuch Band 7, Polyurethane [Plastics handbook, Volume 7, Polyurethanes], chapter 3.4. A particular catalyst that can be used is a compound selected from the group of the amines and organylmetal compounds, preferably from the group of the organyltin compounds and of the organylbismuth compounds, and particularly preferably dibutyltin dilaurate (DBTL).

The quantity of catalyst added, based on sums of the masses of the polyisocyanate component and of the short chain polyol component, depends on the catalyst used and the reaction conditions such as temperature and time applied. For example a suitable concentration using DBTL is from 0.0001 to 0.500 % by weight, preferably from 0.002 to 0.050 % by weight and particularly preferably from 0.005 to 0.030 % by weight.

### Sealant D

In a preferred embodiment of the present invention the solar module A additionally comprises a sealant D which ensures a good connection between the frame C and the embedded stack B. Moreover, the sealant D may also act as barrier to prevent moisture or air ingress and as buffer to compensate differences in CLTE between the stack B and frame C during temperature cycles.

Sealants have been developed for all kind of requirements and the variety is rather wide. Depending on the actual application the sealant D comprises a polymeric, elastic material that is based on polysilicone, polyesters, polyethers, polyurethans, polyacrylics, thermoplastic elastomers, thermoplastic olefins or rubber polymers. Suitable materials and their properties are well known in the art and commercially available. Starting materials for sealants may include but are not limited to isocyanates, epoxies, acrylates, silicones, olefins, amines, alcohols and carboxylic acids and their derivatives. Often, besides radical scavengers and UV blockers additional fillers such as carbonates, silicates, sulfates, graphite or carbon blacks and other inorganic fillers are used in quite substantial amounts to lower the price, enhance the durability and improve or optimize the mechanical properties.

According to the invention all sealants can be used that exhibits a good weather fastness and provide the required mechanical performance for the sealing of stack B and frame C. The appropriate sealant can be easily selected and purchased from the recommendations given by the producers.

In a preferred embodiment of the invention the sealant D is based on silicone or polyurethanes, preferred are silicones. These are easy to handle and commercially available from different companies, for example Du Pont, Dow Corning, Momentive, Lord, Henkel and Sika.

### Photovoltaic array

In a further embodiment, the present invention relates to a photovoltaic array comprising at least 5, more preferred at least 15 and most preferred at least 25 of the above-defined solar panels connected in a serial fashion, wherein said photovoltaic array has a DC voltage of at least 600 V, more preferred at least 900 Volt, even more preferred of 1400 Volt and most preferred of 1550 Volt or higher. It is understood that due to technical restrictions the voltage in the photovoltaic array should not exceed 5000 Volt in order to avoid short cuts in the wiring..

The term "photovoltaic array" refers to a plurality of individual solar modules which are electrically connected to each other. Said connection may be arranged in a serial or in a parallel fashion. It is, however, essential that at least 12 of the individual modules in the photovoltaic array are connected in a serial fashion because this arrangement is necessary in order to achieve high voltages.

### Use

In a further embodiment, the present invention relates to the use of a reaction mixture comprising at least 50 wt.-% of an aliphatic isocyanates as defined above and glass fibers in a pultrusion process for manufacturing a frame of a solar module.

The term "pultrusion" is well known to the person skilled in the art. It refers to a process for manufacturing composite materials comprising the steps of (i) wetting long fibers of a filler with a reaction mixture and (ii) pulling said wetted fibers through a heated, shaped device, whereby the reaction mixture is cured to give the polymer matrix of the composite material, and the composite material has the shape defined by the shape of the heated device.

The following examples are only intended to illustrate the invention. They shall not limit the scope of the claims in any way.

### Examples

Desmodur® N 3600 is an HDI trimer (NCO functionality > 3) with an NCO content of 23.0 % by weight from Covestro AG. The viscosity is about 1200 mPas at 23 °C (DIN EN ISO 3219/A.3).

Glycerol (1,2,3-Propantriol) with a purity of 99,0 % was sourced from Calbiochem.

Baydur® PUL 20PL05 is a mixture of polyols and auxiliaries from Covestro AG and is used for production of glass fibre-containing profiles composed of polyurethane in the pultrusion process. The viscosity is about 1600 mPas at 20 °C (DIN 53019).

Desmodur® PUL 10PL01 is a mixture of diphenylmethane 4,4'-diisocyanate (MDI) with isomers and higher-functionality homologs having an NCO content of about 31 % by weight from Covestro AG and is used for production of glass fibre-containing profiles composed of polyurethane in the pultrusion process. The viscosity is 160-240 mPas at 25 °C (2011-0248603-94).

Dibutyltin dilaurate (DBTL) was sourced with a purity of > 99 % by weight from ACROS under the Tinstab® BL277 name.

Polyethylene glycol 400 was sourced with a purity of > 99% by weight from ACROS.

Potassium acetate was sourced with a purity of > 99% by weight from ACROS.

INT - 1940 RTM separating agent was acquired from Axel Plastics Research Laboratories, INC. and, according to the datasheet, is a mixture of organic fatty acids and esters.

Zinc stearate was acquired from SysKem Chemie GmbH.

The glass fiber was glass fiber bundles with standard size for UP, VE and epoxy resins with the product name 'Advantex 399' with 4800 tex from 3B-fibreglass. According to the datasheet, the glass fibers have a diameter of 24 micrometres, are boron-free and consist of E-CR glass. The tensile modulus is 81-83 GPa, the tensile strength 2200-2400 MPa and the density 2.62 g/cm³.

The solar glass pane was purchased from Flat Glass Group, type low iron pattern glass, 3.2 mm thickness.

The solar back sheet was purchased from Jolywood, type TPT-3501.

The encapsulant material was EVA purchased from First Applied Materials, type F406.

The sealant was a silicone sealant from Tonsan, type Tonsan 1527.

### Preparation of the trimerization catalyst

Potassium acetate (50.0 g) was stirred in the PEG 400 (950.0 g) at room temperature until all of it had been dissolved. In this way, a 5 % by weight solution of potassium acetate in PEG 400 was obtained and was used as catalyst without further treatment.

### Preparation of the resin mixture

The isocyanate was initially charged in an open vessel at room temperature and stirred by means of a Dispermat® and dissolver disc at 100 revolutions per minute (rpm). Subsequently, first the separating agent (and optionally the and then the catalyst were added, the stirrer speed was increased to 300 rpm and the whole mixture was stirred for a further 10 min, so as to form a homogeneous mixture. This mixture was used without further treatment for the pultrusion.

### Production of frame C

### Example 1 (inventive example)

### Aliphatic polyurethane-based frame (frame C for inventive example)

A profile for a frame was pultruded using Desmodur N 3600 (8.56 kg), glycerine (1.38 kg), release agent INT-1940 RTM (0.30 kg), DBTL (0.008 kg) and glass fiber rovings. The rovings were pulled into an injection box in which the resin mixture was pumped, and impregnated. Afterwards, the wetted fibers were passed through a heated dye (temperature 200 °C). The pulling speed was 0.3 m/ min. The resulting profile was used without further treatment.

The samples after performing the weathering test according to SAE J 2527 (10000 h) and the UV tests (A and B; 5000 h) did not show in any change on the surface quality (visual inspection) after 10000 hours. The glass fiber content of the profile was 80.1 wt.-% (DIN EN ISO 1172/A). The coefficient of linear thermal expansion in axial direction was 2.0*10⁻⁶ / K (TM 900026).

### Example 2 (inventive example)

### Aliphatic polyisocyanurate-based frame (frame C for inventive example)

A profile for a frame was pultruded using Desmodur N 3600 (9.45 kg), release agent INT-1940 RTM (0.30 kg), trimerisation catalyst KOAc in PEG (0.2 kg), zinc stearate (0.05 kg) and glass fiber rovings.

The rovings were pulled into an injection box in which the resin mixture was pumped, and impregnated. Afterwards, the wetted fibers were passed through a heated dye (temperature 200 °C). The pulling speed was 0.3 m/ min. The resulting profile was used without further treatment.

The samples after performing the weathering test according to SAE J 2527 (10000 h) and the UV tests (A and B); 5000 h) did not show any change on the surface quality or (visual inspection) after 10000 hours. The glass fiber content of the profile was 80.8 wt.-% (DIN EN ISO 1172/A). The coefficient of linear thermal expansion in axial direction was 4.7*10⁻⁶ / K (TM 900026).

### Example for solar module A (inventive example 3)

A sandwich stack consisting of a pane of glass (solar glass, 3.2mm, 1.60 m x 1.00 m), EVA-sheet, wired solar cells, EVA-sheet and a back sheet was assembled by vacuum lamination process as well known in the industry. The whole circumference of the stack was enclosed by the frame C of example 2 and using a silicone sealant. The finished solar module assembly was subjected to the tests according to standard IEC 61215:2005 and passed these. In addition, the finished solar module was put outdoors (Shanghai) for more than 12 months without any change of appearance.

### Example for solar module A (inventive example 4)

A sandwich stack consisting of a pane of glass (solar glass, 3.2mm, 1.60 m x 1.00 m), EVA-sheet, wired solar cells, EVA-sheet and a back sheet was assembled by vacuum lamination process as well known in the industry. The whole circumference of the stack was enclosed by the frame C of example 1 and using a silicone sealant. The finished solar module was put outdoors (Shanghai) for more than 12 months without any change of appearance.

### Aromatic PU frame (Non-inventive example for frame)

A profile for a frame was pultruded using Baydur® PUL 20PL05, Desmodur® PUL 10PL01 and release agent 4 wt.-% and glass fiber. The rovings were pulled into an injection box in which the resin mixture was pumped, and impregnated. Afterwards, the wetted fibers were passed through a heated dye (temperature 160 °C). The pulling speed was 0.6 m/ min. The resulting profile was used without further treatment.

The samples after performing the weathering test showed strong surface changes such as exposed pristine glass fibers on the surface and discoloration. The aromatic polyurethane matrix has not the necessary chemical stability under these test conditions. The test according to SAE J 2527 was already stopped after 1000 h due to sample degradation. The profile showed no required weathering fastness for a solar frame and could not be used for making a solar module.

The non-inventive example showed clearly that non-coated aromatic polyurethane based frames alone are not durable enough for the requirements of frames for solar modules, and need additional protection e.g. by coatings. On the other hand, frames based on a reaction mixture comprising at least 50 wt.-% aliphatic polyisocyanate are durable enough and passed the accelerated weathering tests without any degradation or change.

## Claims

1. A solar module A comprising
a) at least one stack B comprising pane(s) of glass, a polymeric encapsulation material, crystalline silicon cell(s), electrical wiring and optionally a polymer back sheet; and
b) a frame C made of a non-coated thermoset polymeric composite material comprising a polymer matrix which is based on at least 50 wt.-% of an aliphatic polyisocyanate; and
c) optionally at least one sealant D that connects the stack B with frame C.

2. The solar module A of claim 1, wherein the module is of rectangular shape with a minimum side length of 45 cm.

3. The solar module A of claim 1 or 2, wherein at least 20 % of the surface of frame C is non-coated.

4. The solar module of anyone of claims 1 to 3, wherein stack B comprises the components A1 to A5 in the following sequence
(i) A pane of glass A1;
(ii) A transparent encapsulating polymer A2;
(iii) Silicon cells and wiring A3;
(iv) A transparent encapsulating polymer A4; and
(v) A back sheet A5.

5. The solar module of anyone of claims 1 to 4, wherein cumulated at least 25 % of the circumference of stack B are embedded into the frame C.

6. The solar module A of any one of claims 1 to 5, wherein the surface area of the front side of the module A (facing the sun) is between 0.50 m² and 2.0 m².

7. The solar module A of any one of claims 1 to 6, wherein the thermoset polymeric composite material of frame C is manufactured from a reaction mixture comprising short chain polyols.

8. The solar module A of claim 7, wherein the reaction mixture contains at least one short chain polyol selected from the group consisting of glycerol, 1,1,1-trimethylolpropane, 1,1,1-trimethylolethane, pentaerythritol, 1,2,10-decanetriol, 1,2,8-octanetriol and sugar alcohols or a mixture of at least two thereof.

9. The solar module of any one of claims 1 to 6, wherein the thermoset polymeric composite material of frame C is manufactured from a reaction mixture having a molar ratio of isocyanate groups to all groups reactive with isocyanate groups of at least 2 : 1.

10. The solar module A of claim 7 to 9, wherein the reaction mixture contains at least one polyisocyanate selected from the group consisting of 1,6-diisocyanatohexane (HDI), 1,5-diisocyanatopentane (PDI), isophoronediisocyanate (IPDI) and 2,4'- and 4,4'-diisocyanatodicyclohexylmethane (H12MDI) or a mixture of at least two thereof.

11. The solar module A of claim 7 to 10, wherein the reaction mixture contains at least one oligomeric polyisocyanate based on 1,6-diisocyanatohexane (HDI) and/ or 1,5-diisocyanatopentane (PDI) and having a structure selected from the group consisting of uretdione, isocyanurate, allophanate, biuret, iminooxadiazinedione and/ or oxadiazinetrione or a mixture of at least two thereof.

12. The solar module according to any of the previous claims, wherein the difference of the CLTE of the stack B and frame C, calculated by the absolute value (CLTE pane of glass of stack B minus CLTE of frame C) divided by CLTE pane of glass of stack B multiplied by 100 %, is not more than 1000 %.

13. Photovoltaic array comprising at least 5 solar modules A according to any of the previous claims connected in a serial fashion, wherein said photovoltaic array has a DC voltage of at least 600 V.

14. Use of a reaction mixture comprising at least 50 wt.-% of an isocyanates, preferably an isocyanate according to claim 10, and glass fibers in a pultrusion process for manufacturing a frame of a solar module.

15. The use of a frame manufactured in a pultrusion process of a reaction mixture comprising at least 50 wt.-% of an isocyanates, preferably an isocyanate according to claim 10, and glass fibers in a solar module A, wherein the profile of the frame forms accumulated at least 25 % of the circumference of the solar module A.
